Europäisches Patentamt

European Patent Office

Office européen des brevets

(11) Publication number: **0 117 045 B1**

# EUROPEAN PATENT SPECIFICATION

(45) Date of publication of patent specification: **18.12.91** (51) Int. Cl.⁵: **H01L 27/02, H04N 3/14**

(21) Application number: **84300212.2**

(22) Date of filing: **13.01.84**

The file contains technical information submitted
after the application was filed and not included in
this specification

(54) Liquid crystal flat panel display.

(30) Priority: **18.01.83 US 458919**

(43) Date of publication of application:
**29.08.84 Bulletin 84/35**

(45) Publication of the grant of the patent:
**18.12.91 Bulletin 91/51**

(84) Designated Contracting States:
**AT BE CH DE FR GB IT LI LU NL SE**

(56) References cited:
**GB-A- 2 066 566**
**US-A- 2 994 121**
**US-A- 3 768 060**

(73) Proprietor: **ENERGY CONVERSION DEVICES, INC.**
**1675 West Maple Road**
**Troy Michigan 48084(US)**

(72) Inventor: **Johnson, Robert Royce**
**25885 German Mill Road**
**Franklin Michigan 48025(US)**

(74) Representative: **Müller, Hans-Jürgen, Dipl.-Ing. et al**
**Müller, Schupfner & Gauger Maximilian-strasse 6 Postfach 10 11 61**
**W-8000 München 1(DE)**

Note: Within nine months from the publication of the mention of the grant of the European patent, any person
may give notice to the European Patent Office of opposition to the European patent granted. Notice of opposition
shall be filed in a written reasoned statement. It shall not be deemed to have been filed until the opposition fee
has been paid (Art. 99(1) European patent convention).

## Description

The present invention relates to flat panel displays of the type of three address lines for each pixel wherein the distributed diode array facilitates isolation and addressing.

It is known from US-A-3 768 060 to use amorphous semi-conductor materials like semi-conducting glass material for flat image display panels comprising address line crossovers. Transparent row electrodes are affixed to a glass substrate. Column electrodes are distributed in the orthogonal direction with regard to the row electrodes. Sandwiched between the opposing arrays of electrodes are a layer of electrically insulating material, a film of anisotropically-conducting material, a perforated sheet of electrically insulating material, a slab of electroluminescent material and the substrate. Situated within each of the perforations of the sheet is a switch system, each switch-element thereof is formed as a powder. The particles thereof consist of conductive material coated with amorphous semi-conducting material. These particles are solid-layer ovonic switches. By conctrolling the conductivity of such ovonic switches the respective parts of the electroluminescent material are energized. The switches can function as diodes forming two terminal switches.

Furthermore, it is known to use back-to-back-diode or diode ring configurations in electrical contact with but one address line. However, there is no true switching characteristic inherent in either the ring configuration or the back-to-back diode configuration. Both configurations process inherent deficiencies which make their use for addressing the discrete pixels of liquid crystal displays wholly inadequate. There are relatively high threshold switch voltages, a decreased dynamic range, i.e. grey scale performance, and reduced switching speed. The diode ring configuration does not allow the use of reverse currents on alternating frames. Sometimes, there are damages to the liquid crystal material.

The objective of the present invention is to form a flat panel display with high packing density which can be produced with reduced processing steps and lithography control tolerances. Such displays are to be produced on substrates much larger than previously possible.

The invention is claimed in claim 1 and subclaims refer to preferred embodiments of the invention.

A flat panel display according to a preferred embodiment of the invention comprises a first plurality of conductors, a second plurality of conductors spaced from the first plurality of conductors and crossing the first plurality of conductors at an angle forming crossover points therewith, at least a pair of electrodes, light influencing material between the electrodes, and a plurality of selection diodes between the first and second conductors at the crossover points for selectively interconnecting the conductors to facilitate the application of set and reset voltages to the electrodes for operating the light influencing material. The selection diodes are formed of doped amorphous silicon alloy material.

Such flat panel displays can be easily produced and also a great packing density can be reached.

When producing such flat panel displays it is possible to use methods of depositing amorphous silicon alloys onto large areas substrates as known by US-A-4 217 374 and 4 226 898. Silicon is the base of the huge crystalline semi-conductor industry and is the material which is utilized in substantially all of the commercial integrated circuits now produced. However, contrary to the present invention in conventional crystalline integrated circuit technology the small area crystal waver limits the overall size of the integrated circuits which can be formed thereon. That means that the conventional crystalline integrated circuit technology does not allow the production of large scale areas such as in the display technology. Amorphous silicon however can be made faster and easier, at lower temperatures and in larger areas than the crystal silicon and it can be deposited in layers on top of conductors as well as below conductors.

In accordance with the glow discharge methods described in US-A-4 226 898 and by vapor deposition as described in US-A 4 217 374 fluorine can be introduced into the amorphous silicon semiconductor alloy to substantially reduce the density of localized states therein. Activated fluorine especially readilly diffuses into and bonds to the amorphous silicon in the amorphous body because the small size of the fluorine atoms enables them to be readilly introduced the amorphous body. The fluorine bonds to the dangling bonds of the silicon and forms what is believed to be a partially ionic stable bond with flexible bonding angles which results in a more stable and more efficient compensation or alteration than is formed by hydrogen and other compensating or altering agents. Fluorine also combines in a preferable manner with silicon and hydrogen. Such alloying amount of fluorine and hydrogen may be in the range of 1 to 5% or greater. It is believed that the alloy so formed has a lower density of defect states in the energy gap than that achieved by the mere neutralisation of dangling bonds and similar defect states.

The semi-conductor bodies of the selection diode means formed from amorphous silicon alloys include an intrinsic region and a pair of doped regions on opposite respective sides of the intrinsic region between the intrinsic region and the first and second address lines. Selected address lines are used as electrodes to apply an electric field across the liquid crystal material.

Preferred embodiments of the invention are described by way of example with reference to the drawings accompanying the specification in which:

Figures 1 and 2 are partial side views from perpendicular frames of reference, illustrating a stage of fabrication of the flat panel display according to the present invention;

Figure 3 is a schematic circuit diagram of a flat panel display cell according to the present invention;

Figure 4 is a partial respective view of a specific embodiment of the flat panel display cell according to the present invention.

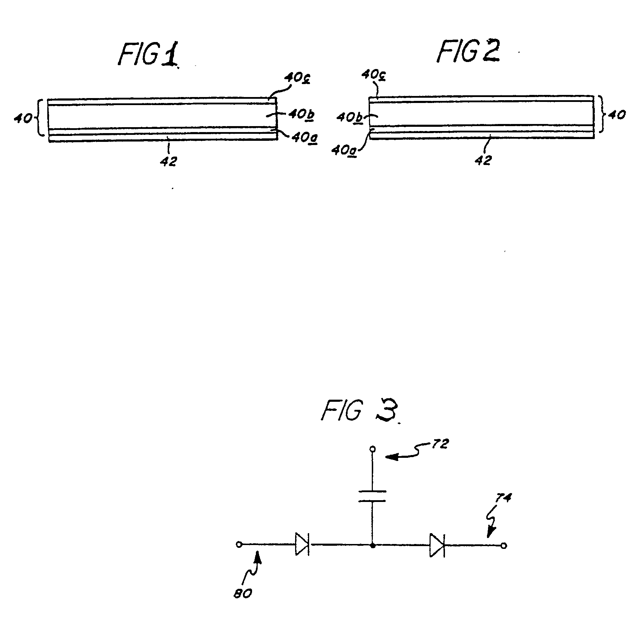

Figs 1 and 2 illustrate the fabrication process of a diode matrix array for a flat panel display. As can be seen in Figs. 1 and 2, an amorphous silicon alloy p-i-n selection or diode structure 40 is first formed on a conductive substrate 42. The selection means structure comprises a diode 40 formed by a p-type amorphous silicon alloy region 40a, an intrinsic amorphous silicon alloy region 40b, and an n-type amorphous silicon alloy region 40c.

Amorphous silicon alloys can be deposited in multiple layers over large area substrates to form such structures in high volume, continuous processing systems. Continuous processing systems of this kind are disclosed, for example, in US-A-4,400,409 and US-A-4,410,558. As disclosed in these patents, which are incorporated herein by reference, a substrate formed from stainless steel, for example, may be continuously advanced through a succession of deposition chambers, wherein each chamber is dedicated to the deposition of a specific material.

In making a p-i-n type configuration, a single deposition chamber system can be used for batch processing or preferably, a multiple chamber system can be used wherein a first chamber is used for depositing a p-type amorphous silicon alloy, a second chamber is used for depositing an intrinsic amorphous silicon alloy, and a third chamber is used for depositing an n-type amorphous silicon alloy. Since each deposited alloy, and especially the intrinsic alloy must be of high purity, the deposition environment in the intrinsic deposition chamber is preferably isolated from undesirable doping constituents within the other chambers to prevent the diffusion of doping constituents into the intrinsic chamber. In the previously mentioned patents, wherein the systems are primarily concerned with the production of photovoltaic cells, isolation between the chambers is accomplished by gas gates through which unidirectional gas flow is established and through which an inert gas may be "swept" about the web of substrate material.

In the previously mentioned patents, deposition of the amorphous silicon alloy materials onto the large area continuous substrate is accomplished by glow discharge decomposition of the process gases. Among these processes, radio frequency energy glow discharge processes have been found suitable for the continuous production of amorphous semiconductors, the first use of which has been as photovoltaic devices. Also, a new and improved process for making amorphous semiconductor alloys and devices has recently been discovered. This process utilizes microwave energy to decompose the reaction gases to cause the deposition of improved amorphous semiconductor materials. This process provides substantially increased deposition rates and reaction gas feed stock utilization. Microwave glow discharge processes can also be utilized in high volume mass production of devices and to make layered structures.

After the p-i-n amorphous silicon alloy structure 40 is formed on the substrate 42, the top layer of conductive material from which will be formed the first plurality of address lines is formed on the selection means or diode structure 40. The lines can be formed in parallel bands, for example, by conventional photolithography techniques of the type well known in the art.

After the first plurality of address lines are formed, the second plurality of address lines are formed by removing selected portions of the substrate 42. This can be accomplished again, for example, by conventional photolithography techniques.

The resulting structure represents a useful device in and of itself for many applications. This is due to the limited lateral conductivity of the amorphous silicon alloys comprising the diode structure 40.

Should further electrical isolation be desired, the amorphous silicon diode structure 40 is etched to form channels or grooves in the areas thereof left exposed by the address lines. As a result, the address lines can be used as a mask during the etching operation. The amorphous silicon alloy diode 40 need not be etched all the way through. In many cases, only the doped p and n-type regions need be etched through because these regions are of higher conductivity than the intrinsic region.

Although not illustrated, a potting compound can be introduced into the grooves or channels after the etching process. This can be done to provide increased structural integrity for the finished device. Alternatively, the diode structure can be attached to another non-conductive substrate to provide increased structural integrity.

As an alternative to the etching operation the additional electrical isolation between the diodes can also be provided by oxidizing the amorphous silicon alloy diode structure in the selected areas left exposed by the address lines. This can be accomplished by using the address lines as a mask and by either implanting oxygen into the selected areas of the amorphous silicon alloys or by exposing the entire structure to a high temperature oxidizing atmosphere. The resulting device will then include oxidized regions in the selected areas. Whether the etching or oxidizing process is employed to provide the additional electrical isolation between the diodes, the electrical conductivity of the diode 40 in the selected areas will be modified by being decreased to thereby increase the electrical isolation between the diodes.

Not only can the distributed electronic diode matrix array be formed over large area substrates, but the packing density thereof is greatly increased by the present invention over prior art structures regardless of the lithography feature size used. This results because only one lithography step is necessary in fabricating the diode matrix, that being in forming the address lines. Thereafter, the address lines themselves can be used as masks for further processing.

By using the distributed diode array and the fabrication techniques previously described, a flat panel display can be fabricated with the additional technique of forming top conductors in a desired shape to form display electrodes.

Fig. 3 illustrates a schematic circuit diagram of a switching element
comprising three terminals 72, 74, and 80 forming anode-to-cathode diodes rather than two terminal back-to-back diodes or diode rings.

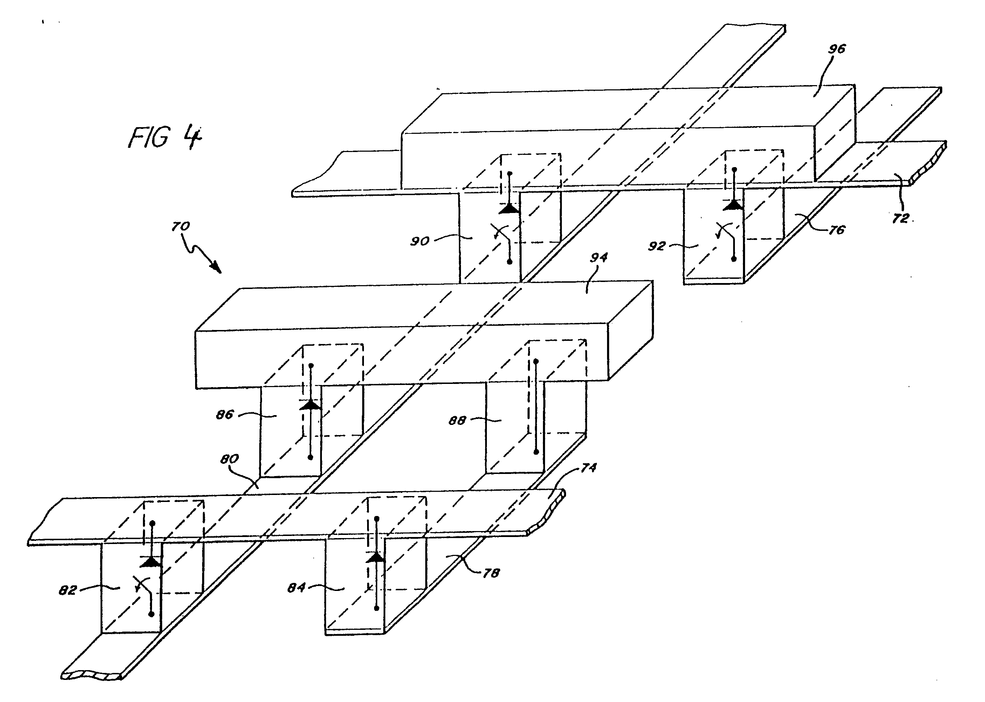

Fig. 4 illustrates a horizontal liquid crystal cell or pixel 70. It is to be understood that Fig. 4 shows only one such cell 70 and that many such cells can be made with it to form a flat panel display.

The cell 70 includes top conductors or leads 72 and 74, bottom conductors or leads 76, 78 and 80, a plurality of diode 82, 84, 86, 88, 90, and 92, and a pair of display electrodes 94 and 96, electrode 94 being directly over diode bodies 86 and 88 and electrode 96 being formed over conductor 72. As can be seen in the figure the top conductors 72 and 74 are substantially parallel. They cross the bottom conductors 76, 78, and 80 and are spaced therefrom to form a plurality of crossover points. Within these crossover points and between the conductors are the diode bodies 82, 84, 90, and 92. The electrode 94 also crosses conductors 78 and 80 to form a pair of crossover points wherein diode bodies 86 and 88 are located. The diodes 82, 90, and 92 are open circuited and the diode body 88 is fused to a high conductivity state. Diodes 84 and 86 have been left to function as diodes.

Although not shown so as to not unduly confuse the figure, a light influencing material, such as a liquid crystal material, is included between the electrodes 94 and 96. By the term "light influencing material" is meant any material which emits light or can be used to selectively vary the intensity, phase or polarization of light either being reflected from or transmitted through the material. Liquid crystal material is only one such material having these characteristics. In order to set the liquid crystal, conductors 72 and 80 are energized. To reset the liquid crystal, conductors 72 and 74 are energized.

The structure of Fig. 4 can be fabricated by starting with the selection means or diode structure deposited onto a conductive substrate as described above. Thereafter, the top conductors and electrodes are deposited onto the diode structure in the configuration as shown. Thereafter, the substrate is etched to form the bottom conductors 76, 78, and 80. Then, the areas of amorphous silicon left exposed by the conductors and electrodes are etched using the conductors and electrodes as a mask. Diodes 82, 90 and 92 are then open circuited by passing a current therethrough sufficient to vaporize the material forming the diodes and diode body 88 is fused. Lastly, the liquid crystal material is introduced between the electrodes 94 and 96.

It may be desired to fill the open areas between the diode bodies and the conductors with a potting compound. This would provide added structural integrity for the cell 70.

As can be appreciated, since large area substrate and diode structures can be employed as starting materials, large area flat panel displays can be made in accordance with the present invention. Also, because relatively few lithographic steps need be performed to make the device, small cell size and hence, increased packing density and resolution can be obtained.

Many modifications and variations of the present invention are possible in light of the above teachings. For example, the amorphous silicon diode bodies can have numerous sizes and shapes and can also have an n-i-p configuration. Also, multiple p-i-n structures can be deposited in tandem to form multiple diode structures. When several layers of conductors are deposited, each separated by a layer of thin film semiconductor material, a multi-level structure is formed with many levels of electrically interconnectable programmable diode cells. Multiple diode structures would be desired for some operating voltage and current requirements and multi-level structures are desired for maximum gate or bit density and minimum interconnecting circuit lengths.

By the term "amorphous" is meant an alloy or material which has long range disorder, although it can have short or intermediate order or even contain at times crystalline inclusions.

**Claims**

1. Flat panel display comprising: at least one pixel (70), said pixel including three address leads (72, 74, 80); first and second diodes (84, 86) connected together, with the cathode of said first diode (86) electrically connected to the anode of said second diode (84), said diodes (84, 86) being connected between two of said address leads (74, 80), with the anode of said first diode connected to a first address lead (80) and the cathode of said second diode (84) connected to a second address lead (74); each of said diodes (84, 86) being formed of a first layer (40a) of doped amorphous silicon alloy material, a layer (40b) of intrinsic amorphous silicon alloy material overlying said first doped layer (40a), and a second doped layer (40c) of amorphous silicon alloy material overlying said intrinsic layer (40b); said first and second doped amorphous silicon layers (40a, 40c) being opposite in conductivity type; a first conductive electrode (94) electrically connected to the cathode of said first diode (86) and to the anode of said second diode (84); a second conductive electrode (96) spaced with respect to said first electrode (94); said second electrode electrically connected to the third address lead (72); and liquid crystal material disposed between said electrodes (94, 96).

2. Flat panel display as claimed in claim 1, **characterized in that** each of said layers (40a, 40b, 40c) forming said diodes (40; 84, 86) includes hydrogenated amorphous silicon alloy material and said layers are formed as thin films.

3. Flat panel display as claimed in claim 2, **characterized in that** each of said thin film layers (40a, 40b, 40c) of hydrogenated amorphous silicon alloy material further includes fluorine.

4. Flat panel display as claimed in one of the claims 1-3, **characterized in that** said pair of electrodes (94, 96) are horizontally and substantially coplanar arranged with respect to said liquid crystal material.

5. Flat panel display as claimed in one of the claims 1-4,

**characterized in that** said pair of electrodes are vertically arranged with respect to said liquid crystal material.

**Revendications**

1. Afficheur à écran plat comprenant : au moins un pixel (70), le pixel comportant trois conducteurs d'adresse (72, 74, 80) ; des première et seconde diodes (84, 86) connectées ensemble, avec la cathode de la première diode (86) connectée électriquement à l'anode de la seconde diode (84), les diodes (84, 86) étant connectées entre deux des conducteurs d'adresse (74, 80), avec l'anode de la première diode connectée à un premier conducteur d'adresse (80) et la cathode de la seconde diode (84) connectée à un second conducteur d'adresse (74) ; chacune des diodes (84, 86) étant formée d'une première couche (40a) d'un matériau d'alliage de silicium dopé amorphe, d'une couche (40b) d'un matériau d'alliage de silicium amorphe intrinsèque recouvrant la première couche dopée (40a), et une seconde couche dopée (40c) d'un matériau d'alliage de silicium amorphe recouvrant la couche intrinsèque (40b) ; les première et seconde couches de silicium amorphe dopées (40a, 40c) étant d'un type de conductivité opposé ; une première électrode conductrice (94) connectée électriquement à la cathode de la première diode (86) et à l'anode de la seconde diode (84) ; une seconde électrode conductrice (96) séparée par rapport à la première électrode (94) ; la seconde électrode étant connectée électriquement au troisième conducteur d'adresse (72) ; et un matériau de cristaux liquides disposé entre les électrodes (94, 96).

2. Afficheur à écran plat selon la revendication 1, caractérisé en ce que chacune des couches (40a, 40b, 40c) formant les diodes (40 ; 84, 86) comporte un matériau d'alliage de silicium amorphe hydrogéné et les couches sont formées comme des films minces.

3. Afficheur à écran plat selon la revendication 2, caractérisé en ce que chacune des couches de film mince (40a, 40b, 40c) du matériau d'alliage de silicium amorphe hydrogéné comprend de plus de la fluorine.

4. Afficheur à écran plat selon l'une quelconque des revendications 1 à 3, caractérisé en ce que la paire d'électrodes (94, 96) est disposée horizontalement et pratiquement coplanaire par rapport au matériau de cristaux liquides.

5. Afficheur à écran plat selon l'une quelconque des revendications 1 à 4, caractérisé en ce que la paire d'électrodes est disposée verticalement par rapport au matériau de cristaux liquides.

**Patentansprüche**

1. Flachfeldanzeigevorrichtung, **gekennzeichnet durch** wenigstens ein Bildelement (70), das drei Adreßleitungen (72, 74, 80) hat; eine erste und eine zweite Diode (84, 86), die zusammengeschaltet sind, wobei die Kathode der ersten Diode (86) mit der Anode der zweiten Diode (84) elektrisch gekoppelt ist und die Dioden (84, 86) zwischen zwei der Adreßleitungen (74, 80) geschaltet sind, wobei die Anode der ersten Diode mit einer ersten Adreßleitung (80) und die Kathode der zweiten Diode (84) mit einer zweiten Adreßleitung (74) gekoppelt ist; wobei jede der Dioden (84, 86) aus einer ersten Schicht (40a) eines dotierten amorphen Siliciumlegierungsmaterials, einer Schicht (40b) von eigenleitendem amorphem Siliciumlegierungsmaterial, die über der ersten dotierten Schicht (40a) liegt, und einer zweiten dotierten Schicht (40c) von amorphem Siliciumlegierungsmaterial, die über der eigenleitenden Schicht (40b) liegt, gebildet ist; wobei die erste und die zweite dotierte amorphe Siliciumschicht (40a, 40c) vom entgegengesetzten Leitfähigkeitstyp sind; eine mit der Kathode der ersten Diode (86) und der Anode der zweiten Diode (84) elektrisch gekoppelte erste leitende Elektrode (94); eine in bezug auf die erste Elektrode (94) im Abstand befindliche zweite leitende Elektrode (96); wobei die zweite ELektrode mit der dritten Adreßleitung (72) elektrisch gekoppelt ist; und ein zwischen den Elektroden (94, 96) angeordnetes Flüssigkristallmaterial.

2. Flachfeldanzeigevorrichtung nach Anspruch 1, **dadurch gekennzeichnet,** daß jede der Schichten (40a, 40b, 40c), die die Dioden (40; 84, 86) bilden, hydriertes amorphes Siliciumlegierungsmaterial aufweist und die Schichten als Dünnschichten gebildet sind.

3. Flachfeldanzeigevorrichtung nach Anspruch 2, **dadurch gekennzeichnet,** daß jede der Dünnschichten (40a, 40b, 40c) von hydriertem amorphem Siliciumlegierungsmaterial außerdem Fluor aufweist.

4. Flachfeldanzeigevorrichtung nach einem der Ansprüche 1-3,
**dadurch gekennzeichnet,**
daß das Paar von Elektroden (94, 96) in bezug auf das Flüssigkristallmaterial horizontal und im wesentlichen komplanar angeordnet ist.

5. Flachfeldanzeigevorrichtung nach einem der Ansprüche 1-4,
**dadurch gekennzeichnet,**
daß das Paar von Elektroden in bezug auf das Flüssigkristallmaterial vertikal angeordnet ist.

FIG 1

40 { 
40c
40b
40a
42

FIG 2

40c
40b
40a
42
} 40

FIG 3.

72

74

80

FIG 4

EP 0 117 045 B1